# EUROPEAN PATENT APPLICATION

(11) **EP 3 381 874 A1**
(43) Date of publication of application: **03.10.2018**
(21) Application number: 17164324.0
(22) Date of filing: 31.03.2017
(51) Int. Cl.: C03C 17/00

(54) **FEEDING DEVICE FOR COATING APPARATUS, COATING APPARATUS COMPRISING IT AND PROCESS USING IT**

(71) Applicant: ARKEMA B.V., 3196 Ke Vondelingenplaat-Rotterdam (NL)
(72) Inventor: VAN DIS, Bram, 4756 AN KRUISLAND (NL)
(74) Representative: Senff, Holger

(57) **Abstract**

The present invention relates to a feeding device for a coating compound or a precursor of a coating compound.

In particular it relates to a feeding device for coating apparatus also called coating tunnel or coating hood for applying the protective coatings to glass containers.

More particularly the present invention relates to a feeding device for a coating apparatus also called coating tunnel or coating hood for applying the protective coatings to glass containers, a coating apparatus comprising such a feeding device and a process for applying the protective coatings to glass containers using such a feeding device.

## Description

### [Field of the invention]

The present invention relates to a feeding device for a coating compound or a precursor of a coating compound.

In particular it relates to a feeding device for coating apparatus also called coating tunnel or coating hood for applying the protective coatings to glass containers.

More particularly the present invention relates to a feeding device for a coating apparatus also called coating tunnel or coating hood for applying the protective coatings to glass containers, a coating apparatus comprising such a feeding device and a process for applying the protective coatings to glass containers using such a feeding device.

### [Technical problem]

Hollow glass containers are produced from molten glass at molds at high temperatures. As the surface of these containers is fragile and in order to preserve the strength of the glass and to prevent any direct glass to glass contact of the respective containers in order to avoid damage, they are surface coated directly after forming of the container.

Such a coating that includes tin or tin tetrachloride, titanium or other heat decomposable metallic or organometallic compounds protects the glass container surface in from damage such as abrasions and scratches, which result in a loss of tensile strength for the glass container. The need for high tensile strength in a glass container is particularly acute when containers are mass produced, move rapidly in close proximity along high speed conveyor lines.

This coating application is done inside a coating apparatus also called a coating tunnel or coating hood with a so called hot end coating by chemical vapor deposition usually in forming a thin layer of a metal oxide, for example tin oxide. The objective is to coat the outside of the bottle with a homogenous even layer except for the so called finish.

The coating tunnel or coating hood receives the glass containers via a conveyer belt from the glass container making equipment with a relatively high speed, meaning between 0.3 up to 1.5 m/s which corresponds to approximately 90 to 700 glass containers per minute. The temperature of the containers excess 400°C at the surface of the containers, so that when the heat decomposable inorganic metallic or organometallic compound (coating compound) is applied thereto, said compound reacts immediately and is converted to a metal oxide coating. The coating compound is fed in the coating tunnel, usually in liquid form, is vaporized and circulates inside with the aid of a carrier gas around the passing glass containers.

As the glass containers pass the coating hood at this high speed they risk to draw the coating compound out of the tunnel when leaving the hood through the outlet. The coating compound can attack building components and give health and safety issues. A venting system has to be installed for above mentioned reasons. For avoiding and minimizing this, the carrier gas comprising the coating compound is sucked into an exhaust system and is discarded. Consequently the coating compounds and chemicals are lost and the coating performance in view of introduced coating chemical is rather low.

On the other side when the coating compound is added or fed in liquid form directly into the tunnel, there is a local peak of concentration near the feeding point, which could yield to thicker coating at certain parts or very inhomogeneous distribution of the thickness of the coating over the surface of the container. In order to apply the minimum necessary coating thickness on the whole required to be coated surface of the glass containers more coating compound has to be introduced in order to guarantee the required concentration of the coating chemical in the coating hood or tunnel for the chemical vapor deposition.

There is still the need for more efficient glass coating hoods, with low losses of the coating compound material to the atmosphere, reduce the exposure in the surroundings of the hood towards the coating chemicals, reduce the loss of coating compound and a homogeneous application of the coating on the glass container.

An objective of the present invention is to reduce the exposure in the surroundings of the hood towards the coating chemicals and to reduce the loss of coating compound.

Another objective of the present invention is to have a more homogenous distribution of the coating on the surface of the glass containers and reduce the variation of the thickness of the coating on the glass container surface.

Another objective of the present invention is to lower the discharge of the coating chemical and reducing the pressure inside the coating apparatus relative to the surroundings.

An objective of the present invention is to have a lower consumption of the coating chemical while applying the same thickness of coating to the glass container.

Still another objective of the present invention is to lower the emissions of chemicals in the coating area and near the coating tunnel or coating hood and reduce the exposure of chemicals in the surrounding working area.

An additional objective of the present invention is to provide a coating hood with a better efficiency, coating more bottles at the same time.

Surprisingly it has been found that with a specific feeding device, some or several of before mentioned problems can be solved.

### [BACKGROUND OF THE INVENTION]Prior art

Coating apparatus for glass containers and the respective standard components are well known from the prior art.

The document US 4,389,234 describes a glass coating hood possessing two or multiple loops. The coating is first fed into an innermost loop and then in an outermost loop. There is also a possibility of using a third loop, but all loops are recirculating loops in order to make better use of the coating material. Consequently the concentration of the coating compound decreases which each recirculating loop. At the end the non used coating compound enters an exhaust system.

The document US 5,140,940 describes also a double loop coating hood, as described before. The coating apparatus based on its respective embodiments contains single or multiple air circulating loops.

The document EP0378116 describes a hot end coating apparatus. The hot end coating apparatus has two additional separate air circuits in the inlet and outlet region of a vapour-deposition hood. The air circuits produce two opposite flow zones flowing through the vapour-deposition hood in the transverse direction, the inner flow zone being enriched to the maximum degree with a coating agent and the outer flow zone forming a protective air curtain consisting of the used air from the coating zone, the degree of enrichment of the said air being correspondingly lower. However two additional feed points of the coating agent are needed one for each circuit.

The document WO2001/0255503 describes a glass container coating hood having additional loops; in one embodiment one loop of air or in another embodiment the hood uses counter current loops of air for carrying the coating. The coating hood comprises means for shaping the air flow.

The document WO96/33955 describes a method and apparatus for applying a layer to bottles. The method is made by a coating apparatus that comprises a gas curtain screening apparatus arranged before the inlet and/or after the outlet of the coating tunnel. The gas curtain is fed by pure gas, no coating causing chemical is added, nitrogen or ambient air are exemplified, in order to avoid clogging of the outflow openings.

The document WO2014/177651 discloses a coating hood having an air entry and a loop returning the air enriched with the coating compound and carrier gas from the outlet to the inlet of the coating hood.

The document WO2016/207307 discloses a coating hood having an air entry and a loop separation the first transferring the air enriched with the coating compound and carrier gas from the outlet to the inlet of the coating hood the second returning the air enriched with the coating compound and carrier gas close to the air entry of the coating hood.

None of the cited prior art discloses a feeding device or a coating apparatus having such a feeding device for the coating apparatus.

### [Brief description of the invention]

Surprisingly it has been discovered that a feeding device (100) comprising a hollow tube (110) comprising an entry (130) where a coating compound or a precursor of a coating compound is added and an exit (140), helps to add easily a coating compound or a precursor of a coating compound in a coating apparatus for glass containers.

Surprisingly it has been discovered that a coating apparatus for applying a coating on glass containers with a chemical compound comprising:
a housing (2) with a coating tunnel,
a conveyer belt (3) moving the containers (20) through the coating tunnel from the inlet (5) to the outlet (6) of the said coating tunnel,
at least one circuit(7) for circulation of a coating compound and
a feeding device (100) comprising a hollow tube (110) comprising an entry (130) where a coating compound or a precursor of a coating compound is added and an exit (140), ;
solves some of the above mentioned problems, especially it helps to add easily a coating compound or a precursor of a coating compound in a coating apparatus for glass containers.

It has also been found that a process of applying a coating on the surface of glass containers comprising the steps of:
- conveying the glass containers (20) on a conveyer belt (3) through a coating tunnel inside a housing (2) from the inlet (5) to the outlet (6),
- circulating a coating compound through the coating tunnel with a circuit (7),
- using a feeding device (100) comprising a hollow tube (110) comprising an entry (130) where a coating compound or a precursor of a coating compound is added and an exit (140) for introducing coating compound into
can solve some the above mentioned problems, especially it helps to add easily a coating compound or a precursor of a coating compound in a coating apparatus for glass containers.

Surprisingly it has also been discovered that the use of a feeding device (100) comprising a hollow tube (110) comprising an entry (130) where a coating compound or a precursor of a coating compound is added and an exit (140), in a coating apparatus for applying a coating on glass containers with a chemical compound comprising:
a housing (2) with a coating tunnel,
a conveyer belt (3) moving the containers (20) through the coating tunnel from the inlet (5) to the outlet (6) of the said coating tunnel,
at least one circuit(7) for circulation of a coating compound solves some the above mentioned problems, especially it helps to add easily a coating compound or a precursor of a coating compound in a coating apparatus for glass containers.

Surprisingly it has also been discovered that the introduction of a feeding device (100) comprising a hollow tube (110) comprising an entry (130) where a coating compound or a precursor of a coating compound is added and an exit (140), to the coating apparatus for applying a coating on glass containers with a chemical compound, reduces the consumption of the coating chemical and/or lower the discharge of the coating chemical.

The invention is best understood from the following detailed description when read in connected with the accompanying drawings with the following figures:
Figure 1: 1a) feeding device (100) comprising a hollow tube (110) comprising an entry (130) where a coating compound or a precursor of a coating compound is added and an exit (140). Variations are shown in figure 1b) and 1c) comprising additionally heating means.
Figure 2: variations of the tube (110) of feeding device (100) having different forms and lengths.
Figure 3: tube (110) of feeding device (100) having heating means and a valve.
Figure 4: schematic representation of one embodiment of the feeding device (100) having additionally a lateral entry (150).
Figure 5a: schematic representation of existing hood from the state of the art.
Figure 5b: schematic representation of another existing hood from the state of the art.
Figure 6: schematic representation of existing hood from the state of the art with shown slots in the inner side wall.
Figure 7: schematic representation of the hood according to one embodiment of the present invention.

### [Detailed description of the invention]

In a first aspect, the present invention relates to a feeding device (100) in form of a hollow tube (110) comprising an entry (130) where a coating compound or a precursor of a coating compound is added into the feeding device (100) and an exit (140) where the coating compound is added into a coating apparatus.

In a second aspect, the present invention relates to a coating apparatus for applying a coating on glass containers with a chemical compound comprising:
- a housing (2) with a coating tunnel
- a conveyer belt (3) moving the containers (20) through the coating tunnel from the inlet (5) to the outlet (6) of the said coating tunnel
- at least one circuit(7) for circulation of a coating compound and
- a feeding device (100) in form of a hollow tube (110) comprising an entry (130) where a coating compound or a precursor of a coating compound is added into the feeding device (100) and an exit (140) where the coating compound is added into a coating apparatus.

In a third aspect the present invention relates to a process of applying a coating on the surface of glass containers comprising the steps of:
- conveying the glass containers (20) on a conveyer belt (3) through a coating tunnel inside a housing (1) from the inlet (5) to the outlet (6),
- circulating a coating compound through the coating tunnel with a circuit (7)
- adding the coating compound into the coating apparatus with the help of a feeding device (100) in form of a hollow tube (110) comprising an entry (130) where a coating compound or a precursor of a coating compound is added into the feeding device (100) and an exit (140) where the coating compound is added into the coating apparatus.

In a fourth aspect, the present invention relates to the use of a feeding device (100) in form of a hollow tube (110) comprising an entry (130) where a coating compound or a precursor of a coating compound is added into the feeding device (100) and an exit (140) where the coating compound is added into a coating apparatus for applying a coating on glass containers with a chemical compound comprising:
- a housing (2) with a coating tunnel
- a conveyer belt (3) moving the containers (20) through the coating tunnel from the inlet (5) to the outlet (6) of the said coating tunnel
- at least one circuit (7) for circulation of a coating compound.

According to another aspect the present invention relates to a glass container on which a coating has been applied on its surface by a process comprising the steps of:
- conveying the glass container (20) through a coating tunnel from the inlet (5) to the outlet (6),
- circulating a coating compound through the coating tunnel with a circuit (7) comprising (25)
- using feeding device (100) in form of a hollow tube (110) comprising an entry (130) where a coating compound or a precursor of a coating compound is added into the feeding device (100) and an exit (140) where the coating compound is added into the coating apparatus.

According to an additional aspect the present invention relates to the use of a coating apparatus for applying a coating on the surface of a glass container, said coating apparatus is comprising:
a housing (2) with a coating tunnel
a conveyer belt (3) moving the containers (20) through the coating tunnel from the inlet (5) to the outlet (6) of the said coating tunnel
at least one circuit(7) for circulation of a coating compound and
feeding device (100) in form of a hollow tube (110) comprising an entry (130) where a coating compound or a precursor of a coating compound is added into the feeding device (100) and an exit (140) where the coating compound is added into the coating apparatus.

By the generic term "air" as used is denoted the carrier gas that is used for the coating compound. It is obvious that any inert gas or a gas that is inert to the coating compound, the container and the interior of the coating hood, such as nitrogen could be used. Because of its convenience and low cost however the preferred gas is air.

By the term "coating compound" as used in the present invention is denoted a chemical compound that is introduced in the coating apparatus. The coating compound is used directly to coat a surface or it is transformed during the coating application in another compound that forms the coating. In the latter case it could also be called coating generating compound.

By the term "exhaust" as used is denoted the carrier gas that is still loaded with a minor quantity of the coating compound not applied to the glass container that escapes at the entry and especially the outlet of the coating tunnel, where the containers enter and sort.

By the term "loop" as used in the present invention is denoted a circuit for the carrier gas or air loaded with the coating compound that enters and leaves the coating tunnel. Such a loop comprises at least a jet slot and a least one receiving slot that are located on the opposite inner side walls of the hood. The loop could comprises also conduits in form of tubes and pipes. These conduits in form of tubes and pipes are necessary to transport the carrier gas from the receiving slot to the jet slot

By the term "primary loop" as used in the present invention is denoted a circuit that comprises at least a feed point of the coating compound and circulates the carrier gas loaded with the coating compound or air loaded with the coating compound. The loop or circuit enters and leaves twice the coating tunnel by respective jet slots and receiving slots. In other words the loop or circuit makes a complete 360° turn.

By the term "recirculating loop" as used in the present invention is denoted a circuit that does not comprise any feed point and that recirculates the carrier gas loaded with the coating compound or air loaded with the coating compound coming from the primary loop.

By the term "circuit" as used in the present invention is denoted a pathway for the circular flow of the carrier gas or air comprising the coating compound or coating generating compound through the respective parts of the coating apparatus.

**With regard to the feeding device (100), it is** in form of a hollow tube (110) comprising an entry (130) where a coating compound or a precursor of a coating compound is added and an exit (140) where the coating compound is added into a coating apparatus.

The feeding device comprises heating means (120) for heating the coating compound or the precursor of the coating compound. The heating means can be an electrical heating or by a hot fluid or gas or vapor that is circulated around a part of the tube (110). The heating means are for heating up the liquid coating compound or the precursor of the coating compound that enters the feeding device (100) through entry (130). The coating compound or the precursor of the coating compound leaves the feeding device (100) through exit (140) either as hot liquid or already vaporized.

**With regard to the feeding device (100), it is** situated mainly outside of a coating apparatus. Only the exit (140) of the feeding device is inside the coating apparatus (1) defining the feed point (4) or the exit (140) of the feeding device is connected via another tubing for going inside the coating apparatus.

The exit (140) of the feeding device can be prolonged with a another or a thinner tube (170) in order to feed the coating compound or the precursor of the coating compound to the feeding point (4) in the coating apparatus.

The exit (140) of the feeding device can be split up by several tubes in order to feed the coating compound or the precursor of the coating compound at several feeding points inside the coating apparatus.

The feeding device can comprise one or several valves (160).

The feeding device can also comprise a lateral entry (150). The lateral entry (150) can be used to add other compounds to coating compound or the precursor of the coating compound. Through the entry (150) for example a gas or a liquid.

In a first preferred embodiment air is added through the lateral entry (150) in the feeding device (100).

Additionally the coating apparatus for applying a coating on glass containers with a chemical compound comprises blowing means (12), slots (30) in the inner side wall (80).

A circuit (7) for circulation the coating compound is also called loop. The coating apparatus can also comprise several circuits or loops. It comprises at least one circuit or primary loop, where the coating compound or coating generation compound is added. This place where the coating compound or coating generation compound is added is called feed point. This feed point corresponds to the exit (140) of the feeding device (100).

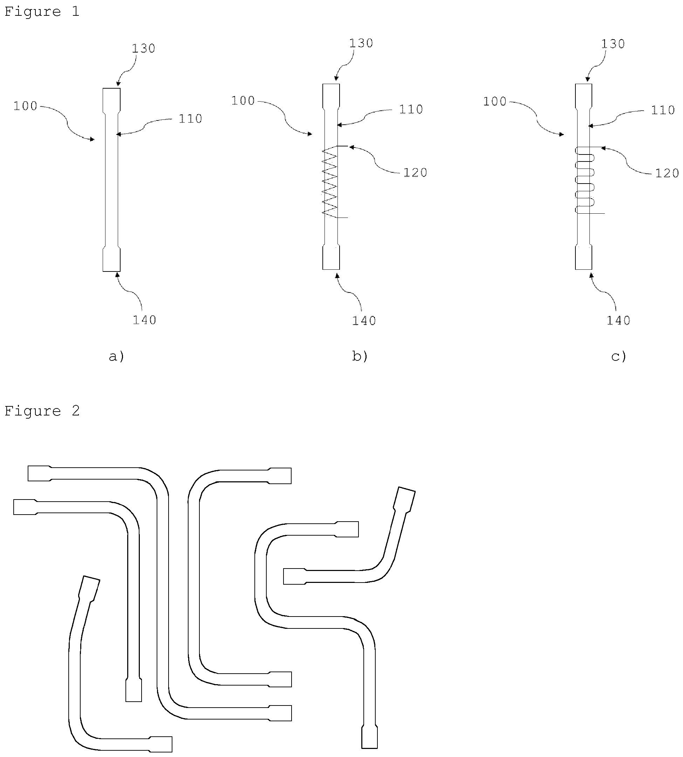

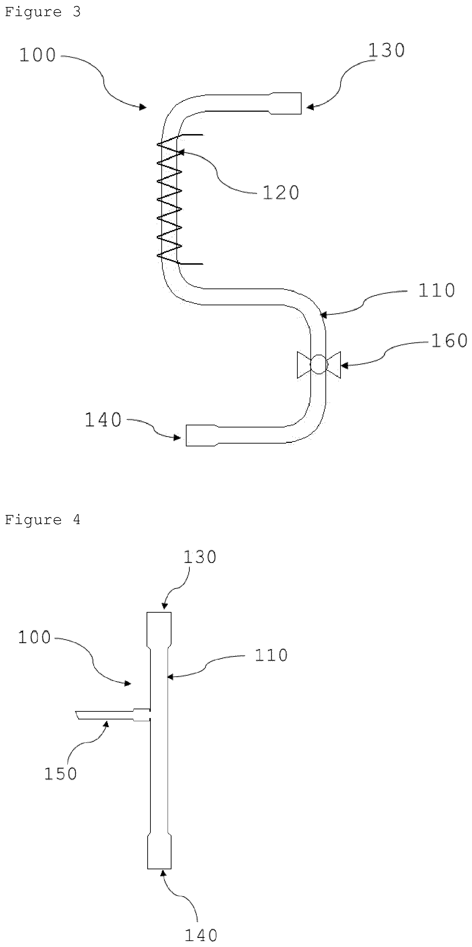

According to a variation of the present invention the coating apparatus can also comprise one or more recirculating loops (8). The recirculating loop or loops (8) is or are after the primary loop (7a) and before the carrier gas flow that is separated, in the sense of the direction of the passing containers on the conveyer belt. Such a recirculating loop (8) is not shown in figure 2 and 3, but is well known from prior art as presented in figure 1.

**The coating apparatus of** the present invention comprises a feeding device (100).

Preferably the pressure inside the coating apparatus is lower than in comparison to the outside. In that case the coating compound or the precursor of the coating compound is sucked out if the feeding device through the exit (140), via the feeding point (4) into the coating apparatus.

Preferably the pressure inside the coating apparatus is at least 1mbar less than on the outside of the coating apparatus.

Preferably the pressure inside the coating apparatus is at most 100mbar less than on the outside of the coating apparatus.

Advantageously the pressure difference between the inside of the coating apparatus and the outside is between 1mmbar and 100mbar.

It is obvious that the pressure p of gases is a function of the temperature T, but the relation between the two of them is well known by the respective physical gas laws.

**With regard to a coating apparatus from the prior art**, an embodiment of said coating apparatus is shown in figure 1a. The coating apparatus comprises a housing (2) with coating tunnel, a conveyer belt (3) moving the containers (20) through the coating tunnel from the inlet (5) to the outlet (6) of the said coating tunnel, one circuit being the primary loop (7) with a least one feed point (4) for the coating compound, one or more circuits being recirculating loops (8), blowing means (12) and exhaust means (11) in proximity of the inlet (5) end outlet (6). Details of such a coating apparatus and its components can be found in document US 4,668,268 or US 4,389,234.

**Still with regard to a coating apparatus from the prior art,** another embodiment of such a coating apparatus is shown in figure 1b. Said coating apparatus comprises a housing (2) with coating tunnel, a conveyer belt (3) moving the containers (20) through the coating tunnel from the inlet (5) to the outlet (6) of the said coating tunnel, one primary loop (7) with a least one feed point (4) for the coating compound, blowing means (12), optionally one or more recirculating loops (8) and a half open loop (9) going from the outlet (6) to the inlet (5) of the coating tunnel. Details of such a coating apparatus and its components can be found in document WO2014/177651.

**Still with regard to a coating apparatus from the prior art,** another embodiment of such a coating apparatus is shown in figure 2. Said coating apparatus comprises a housing (2) with coating tunnel, a conveyer belt (3) moving the containers (20) through the coating tunnel from the inlet (5) to the outlet (6) of the said coating tunnel, blowing means (12) comprising a blower wheel (12a) and a motor (12a) for turning the blower wheel, for circulating the coating compound through the circuits or respective loops of the coating tunnel and inner side wall (80) with slots (30). Details of such a coating apparatus and its components can be found in document US 5,140,940.

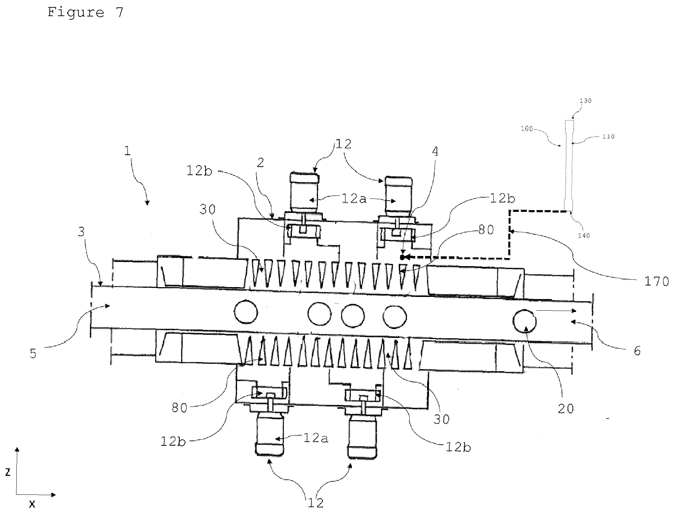

**With regard to the coating apparatus of** the present invention, it is shown schematically in figure 7, said coating apparatus (1) comprises a housing (2) with coating tunnel, a conveyer belt (3) moving the containers (20) through the coating tunnel from the inlet (5) to the outlet (6) of the said coating tunnel, one primary loop (7) with a least one feed point (4) for the coating compound, blowing means (12), and the feeding device (100).

Optionally the coating apparatus of the present invention can comprise one or more recirculating loops.

In a one embodiment the coating hood according to the invention comprises additionally one or more recirculating loops.

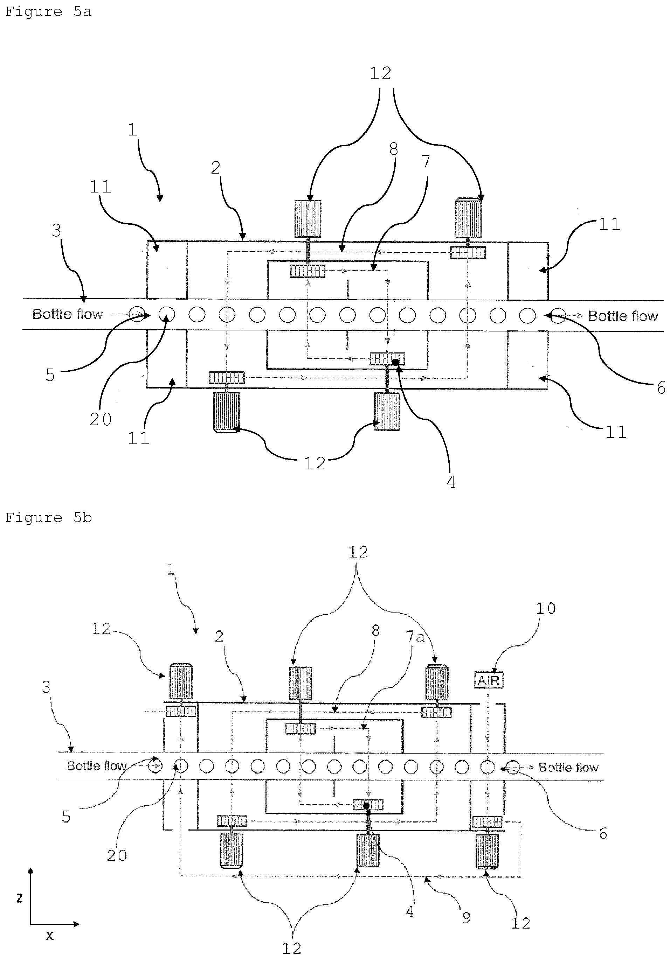

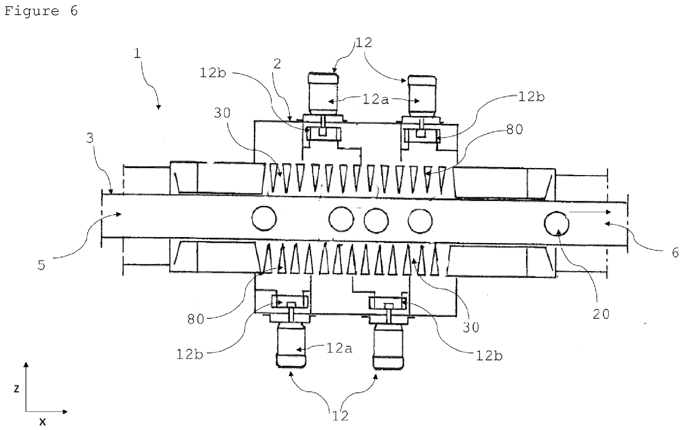

The position of the recirculating loop or recirculating loops can be behind the primary loop (in view of the movement of the conveyer belt) or around the primary loop, latter possibility as shown in figure 5 and 6 of the coating apparatus from the prior art.

Additionally the coating apparatus comprises at least one jet slot (30a) and receiver slot (30b) in the inner side wall (80), which are not shown in the figure 5. The slots (30) are respectively the entry or exit of the circuit (7) or each respective loop towards or from the central chamber of the coating tunnel, where the conveyer belt (3) with the containers (20) passes. By the jet slot (30a) the coating compound or carrier gas enters this chamber. By the receiver slot (30b) the coating compound or carrier gas leaves this chamber.

Preferably each circuit or loop of the coating apparatus (1) comprises at least one jet slot (30a) and receiver slot (30b).

Additionally the coating apparatus comprises blowing means or blowers (12). These blowers (12) keep the carrier gas with the coating compound circulating inside the hood and make it passing through the respective loops. The blower can either push the carrier gas with coating compound forward inside the centre section of the tunnel where the conveyer belt with the container passes or suck it outside. The blowing means (12) comprises a blower wheel (12b) and a motor (12a) for rotating the blower wheel. Depending on the sense of the rotation of the blower wheel and its blades, the carrier gas with the coating compound is either pushed or sucked.

Preferably the circuit (7) or loop comprises at least one blowing means (12). More preferably the coating apparatus of the present invention comprises at least two blowing means (12), the blowing means are on opposite sides of the coating apparatus, as shown in figure 3.

Preferably the two on opposite sides situated blower wheels (12b) of the at least two blowing means circulate in different meaning opposite directions. When looking from one side at the coating apparatus, one blower wheel rotates clockwise, while the other blower wheel on the other side rotates counter clockwise.

Preferably the blower wheel or blower wheels rotate between 100rpm and 10 000rpm, more preferably between 200rpm and 9 000rpm.

Optionally the coating apparatus according to the invention can comprise means for exhaust. This can be either at the inlet or at the outlet or at the inlet and the outlet additional exhaust means are present.

The coating compound is introduced through at least one feed point (4) in to the coating apparatus. This can be an internal feed point as in figure 1 or 3 or an external feed point.

In one embodiment the feed point (4) is based at the primary loop (7) as an internal feed point as shown in figure 3. The coating compound is introduced by the means of pipes, latter are not shown in the figure.

In another embodiment the coating compound is introduced by hot recirculating air as a side stream to dose the coating compound in, which is an external feed.

The hollow glass containers are transported in a single or double line by a conveyer through a tunnel formed in the coating hood under the housing. The conveyer carries the bottles in the direction designated by the arrow, in figures 1, 2 and 3 from left to right.

**With regard to the coating compound** introduced with the feeding device (100) in the coating apparatus at one or more feedings points, it can be chosen from organometallic compounds, metal halides or other suitable compounds as coating compound precursor.

Preferably the coating compound is an organic tin halogenide, advantageously it is monobutyl tin trichloride.

**With regard to the coating** formed at the surface of the containers and applied in the hood it is a metal oxide as SnO2, TiO2, Al2O3 or ZnO. The metal oxide is derived from the decomposition inorganic or organometallic compounds. Latter are the before mentioned coating generating compounds.

In a first preferred embodiment the coating is tin oxide. The tin oxide is derived from the decomposition inorganic or organic tin compound advantageously of an organic tin halogenide, more advantageously from monobutyl tin trichloride.

**With regard to the process** of applying a coating on the surface of glass containers, it comprises the steps of:
- conveying the glass containers (20) on a conveyer belt (3) through a coating tunnel inside a housing (1) from the inlet (5) to the outlet (6),
- circulating a coating compound through the coating tunnel with a circuit (7) comprising a guidance plate (25)
- feeding a coating compound into the coating apparatus with a feeding device (100).

The circulation step of said process, circulates the coating compound or coating generating compounds that is introduced by a feed point (4) with the carrier gas by the help of blowing means (12). The circuit of the circulation step comprises the passage of the side wall (80) via the slots (30) inside the side wall. For entering the inner part of the coating tunnel where the container (20) are on the conveyer belt, the circuit leaves the compartment (70), via the jet slots (30a). On the opposite side the circuit leaves the inner part of the coating tunnel where the container (20) are on the conveyer belt, via receiver slots (30b) and enter the opposite compartment comprising (70). To return to the initial departing point the circuit continues in the same manner as described.

**With regard to the glass container** on which a coating has been applied on its surface by a process comprising the steps of:
- conveying the glass containers (20) on a conveyer belt (3) through a coating tunnel inside a housing (1) from the inlet (5) to the outlet (6),
- circulating a coating compound through the coating tunnel with a circuit (7) comprising a guidance plate (25)
- feeding a coating compound into the coating apparatus with a feeding device (100).

Preferably the glass container on which a coating has been applied on its surface by a process that comprises additionally a step of blowing the gas comprising the coating generating compound with one or more recirculating loops (8) through the coating tunnel, after the circuit of primary loop (7).

**With regard to the glass container** on which a coating has been applied on its surface by a coating apparatus comprising:
- a housing (2) with a coating tunnel
- a conveyer belt (3) moving the containers (20) through the coating tunnel from the inlet (5) to the outlet (6) of the said coating tunnel
- at least one circuit (7) for circulation of a coating compound and
- the feeding device (100).

The coating apparatus according to the invention is used to apply a coating on the surface of a glass containers.

The present invention concerns as well an improved method for applying a hot end coating integrated in the glass container manufacturing process.

### [Figures]

Figure 1: 1a) feeding device (100) comprising a hollow tube (110) comprising an entry (130) where a coating compound or a precursor of a coating compound is added and an exit (140). Variations are shown in figure 1b) and 1c) comprising additionally heating means either electrical heating means as in figure 1b or by circulating a hot fluid or gas or vapor that is around a part of the tube (110).

Figure 2: variations of the tube (110) of feeding device (100) having different forms and lengths. Other possibilities and combinations are possible not shown in figure 2

Figure 3: tube (110) of feeding device (100) having heating means (120) and a valve (160). There could be more valves at different positions.

Figure 4: schematic representation of one embodiment of the feeding device (100) having additionally a lateral entry (150).

**Figure 5a****:** schematic representation of one existing coating apparatus or hood from the state of the art with a recirculating loop.

Coating compound is introduced into the coating apparatus (1) or hood at a feed point (4). The hood (1) comprises a housing (2) and a conveyer belt (3) running there through. Containers (4) are transported on the belt that moves them from the entrance or inlet (5) to the exit outlet (6) of the hood (1).

The containers (20) are only presented diagrammatically by circles.

The hood also comprises one primary loop (7) with a least one feed point (4) for the coating compound, one or more recirculating loops (8) and exhaust means (11) in proximity of the inlet (5) end outlet (6).

**Figure 5b****:** schematic representation of one existing coating apparatus or hood with an additional half loop (9).

Coating compound is introduced into the coating apparatus (1) or hood at a feed point (4). The hood (1) comprises a housing (2) and a conveyer belt (3) running there through. Containers (4) are transported on the belt, that moves them from the entrance or inlet (5) to the exit outlet (6) of the hood (1).

The containers (20) are only presented diagrammatically by circles.

The hood also comprises one primary loop (7) with a least one feed point (4) for the coating compound, one or more recirculating loops (8) and a half open loop (9) going from the outlet (6) to the inlet (5) of the coating tunnel.

**Figure 6****:** schematic representation of another existing coating apparatus or hood from the state of the art where the inner side wall (80) with the slots (30) is more detailed. The hood (1) comprises a housing (2) and a conveyer belt (3) running there through. Containers (4) are transported on the belt that moves them from the entrance or inlet (5) to the exit outlet (6) of the hood (1). Behind the inner side wall (80) with the slots (30) blowing means (12) are shown, comprising a blower wheel (12b) and a motor (12a).

**Figure 7****:** schematic representation of a coating apparatus according to one embodiment of the present invention with the coating apparatus or from the state of the art of figure 6 in combination with the feeding device (100) of figure 1a. Other combinations of different embodiments of feeding device (100) and coating apparatus.

## Claims

1. Feeding device in form of a hollow tube (110) comprising an entry (130) where a coating compound or a precursor of a coating compound is added into the feeding device (100) and an exit (140) where the coating compound is added into a coating apparatus.

2. Feeding device according to claim 1 characterized that comprises heating means (120) for heating the coating compound or the precursor of the coating compound.

3. Feeding device according to claim 2 characterized that the heating means (120) an electrical heating or by hot fluid or gas or vapor that is circulated around a part of the tube (110).

4. Feeding device according to any of claims 1 to 3, characterized that exit (140) of the feeding device is prolonged with an another or a thinner tube (170).

5. Feeding device according to any of claims 1 to 3, characterized that exit (140) of the feeding device has been split up by several tubes.

6. Feeding device according to any of claims 1 to 5, characterized that comprise one or several valves.

7. Feeding device according to any of claims 1 to 6, characterized that also comprise a lateral entry (150).

8. A coating apparatus (1) for applying a coating on glass containers with a chemical compound comprising:
- a housing (2) with a coating tunnel
- a conveyer belt (3) moving the containers (20) through the coating tunnel from the inlet (5) to the outlet (6) of the said coating tunnel
- at least one circuit(7) for circulation of a coating compound and
- a feeding device according to any of claims 1 to 7.

9. The coating apparatus according to claim 8 characterized that the inside the coating apparatus is at least 1mbar less than on the outside of the coating apparatus.

10. The coating apparatus according to any of claims 8 to 9, characterized that the pressure difference between the inside of the coating apparatus and the outside is between 1mmbar and 100mbar.

11. The coating apparatus according to any of claims 8 to 10, characterized that it comprises at least one of the following:
blowing means (12),
at least one feed point (4),
slots (30) in the inner side wall (80).

12. A coating apparatus according to any of claims 8 to 11, wherein the said apparatus comprises at least two blowing means (12), said blowing means are on opposite sides of the coating apparatus.

13. A process of applying a coating on the surface of glass containers comprising the steps of:
- conveying the glass containers (20) on a conveyer belt (3) through a coating tunnel inside a housing (1) from the inlet (5) to the outlet (6),
- circulating a coating compound through the coating tunnel with a circuit (7) comprising
- feeding a coating compound into the coating apparatus with a feeding device according to any of claims 1 to 8.

14. The use of a feeding device according to any of claims 1 to 8 in a coating apparatus for applying a coating on glass containers with a chemical compound, said coating apparatus comprises
- a housing (2) with a coating tunnel
- a conveyer belt (3) moving the containers (20) through the coating tunnel from the inlet (5) to the outlet (6) of the said coating tunnel
- at least one circuit (7) for circulation of a coating compound.

15. Use of a coating apparatus according to any of claims 8 to 12 for applying a coating on the surface of a glass container.
